# EUROPÄISCHE PATENTSCHRIFT

(11) **EP 1 481 577 B1**
(45) Veröffentlichungstag und Bekanntmachung des Hinweises auf die Patenterteilung: **01.09.2010**
(21) Anmeldenummer: 02787388.4
(22) Anmeldetag: 20.11.2002
(51) Int. Cl.: H05K 13/08

(54) **VERFAHREN ZUR QUALIFIZIERUNG VON SUBSTRATE VERARBEITENDEN FERTIGUNGSPROZESSEN UND ZUR DURCHFÜHRUNG DIESER VERFAHREN GEEIGNETE VORRICHTUNGEN**
METHOD AND DEVICES FOR QUALIFYING SUBSTRATE-PROCESSING PRODUCTION PROCESSES
PROCEDES ET DISPOSITIFS POUR DETERMINER LA QUALITE DE PROCESSUS DE FABRICATION AU COURS DESQUELS DES SUBSTRATS SONT TRAITES

(30) Priorität: 22.11.2001 DE 10158643
(43) Veröffentlichungstag der Anmeldung: 01.12.2004
(73) Patentinhaber: SIEMENS AKTIENGESELLSCHAFT, 80333 München (DE)
(72) Erfinder: MEIER, Hartmut, 16321 Bernau (DE); MÜLLER, Bernd, 16259 Falkenberg (DE); WITTREICH, Ulrich, 16727 Velten (DE)
(86) Internationale Anmeldenummer: PCT/DE2002/004308
(87) Internationale Veröffentlichungsnummer: WO 2003/047328

(56) Entgegenhaltungen:
- EP-A- 1 155 767
- EP-B1- 0 545 962
- DE-A- 4 218 515
- DE-A- 10 152 408
- DE-A1- 19 803 305
- DE-C- 19 748 844

## Beschreibung

Die Erfindung bezieht sich auf eine Sensorplatte zur Qualifizierung von Substrate verarbeitenden Fertigungsprozessen. Gemäß der deutschen Patentanmeldung mit dem Aktenzeichen 100 24 676.1, die als Stand der Technik gilt, können als Sensorplatten sogenannte "Touch Panels" verwendet werden, die bei Laptops zur Verschiebung des Mauszeigers bekannt sind. Diese sind berührungssensitiv ausgebildet, so dass der Mauszeiger durch Verfahren eines Fingers auf dem "Touch Panel" verschoben werden kann. Der Substrate verarbeitende Fertigungsprozessschritt, der gemäß der genannten Anmeldung qualifiziert werden soll, ist die Durchleitung des mit Bauelementen bestückten Substrates durch eine Reflowlötanlage. Bei diesem Prozessschritt werden normalerweise durch Bildung von Lotverbindungen die Bauelemente mit dem durch eine Leiterplatte gebildeten Substrat elektrisch kontaktiert, wodurch gleichzeitig eine mechanische Fixierung der Bauelemente erreicht wird.

Bei diesem Verfahren zur Qualifizierung des beschriebenen Prozessschrittes wird das Substrat durch eine Sensorplatte ersetzt, auf der die zu verlötenden Bauelemente platziert werden. Diese wird anstelle des Substrates durch die Reflowlötanlage geführt, wobei ein eventuelles Verrutschen der Bauelemente aufgrund einer in der Reflowlötanlage vorhandenen Luftströmung durch die Sensorplatte erfasst wird. Als mögliche Sensorplatten werden in der Anmeldung die für Laptops verwendeten "Touch Panels" genannt, welche beispielsweise eine drucksensitive Oberfläche aufweisen.

Gemäß der DE 197 48 844 C1 wird eine Testleiterplatte mit Markierungen beschrieben, auf der Dummy-Bausteine mit maschinell abtastbaren Codierungen als Positionsmarken angeordnet werden können, damit mittels der Markierungen und Codierungen eine optische Ermittlung von Lage- und Formabweichungen der auf der Testleiterplatte aufgesetzten Dummy-Bausteine möglich ist.

Gemäß der DE 42 18 515 A1 ist ein Messverfahren für eine Testplatte beschrieben, welches auf der Durchbiegung eines als Biegebalken ausgeführten Abschnittes dieser Testplatte basiert. Dieser Abschnitt der Testplatte ist mit Dehnungsmessstreifen versehen, mit deren Hilfe die Durchbiegung des Biegebalkens gemessen werden kann, die durch die Einprägung einer Druckkraft beispielsweise durch Aufsetzen eines Bauteils hervorgerufen wird.

Aufgabe der Erfindung ist es, eine Sensorplatte anzugeben, die in Verfahren zur Qualifizierung von Substrate verarbeitenden Fertigungsprozessen vergleichsweise vielseitig verwendbar ist. Die Aufgabe wird erfindungsgemäß dadurch gelöst, dass die Sensorplatte an mindestens einer Seite mit einer Matrix aus berührungsunabhängig kapazitiv sensitiven Sensorelementen ausgestattet ist.

Mit der erfindungsgemäßen Sensorplatte wird erreicht, dass die Funktion der Sensorplatte nicht von einer Berührung derselben abhängig ist. Vielmehr wird ein Erfassungsbereich der Sensorplatte geschaffen, welcher sich nicht nur auf die Fläche der Sensorplatte beschränkt, sondern auch innerhalb eines gewissen Abstandes von der Sensorplatte noch die Erzeugung von Messwerten ermöglicht. Hierdurch kann die Sensorplatte vergleichsweise universell eingesetzt werden, weil eine Berührung der Sensorplatte während des zu qualifizierenden Prozessschrittes nicht notwendig ist. Daher kann vorteilhafterweise die Sensorplatte beispielsweise auch unterhalb des zu verarbeitenden Substrates angeordnet werden, wobei Vorgänge qualifizierbar werden, die auf der gegenüberliegenden Seite des zu qualifizierenden Substrates durchgeführt werden.

Gemäß einer weiteren Ausbildung der Erfindung weist die Sensorplatte auf beiden Seiten jeweils eine Matrix aus kapazitiven Sensorelementen auf. Diese Ausgestaltung ist besonders vorteilhaft, wenn die Sensorplatte das zu verarbeitende Substrat im Fertigungsprozess ersetzen soll. Dabei sind dann Messungen möglich, die sich nicht nur auf die zu bearbeitende Seite des Substrates sondern auch auf die dieser Seite abgekehrten Seite beziehen. Beispielsweise kann die Auflagefläche des Substrates in der Fertigungseinrichtung ermittelt werden.

Gemäß einer weiteren Ausgestaltung der Erfindung weist die Sensorplatte eine Markierung zur Bestimmung ihrer Lage in einer für den Fertigungsprozess vorgesehenen Fertigungseinrichtung auf. Diese Markierungen können beispielsweise durch einen farbigen Aufdruck wie zum Beispiel ein Fadenkreuz erzeugt werden. Hierdurch ist eine Positionierung in der Fertigungseinrichtung auf einfache Weise möglich, hierbei können vorteilhafterweise optische Erkennungssysteme genutzt werden, wie diese in Fertigungseinrichtungen von Substrate verarbeitenden Fertigungsprozessen, wie zum Beispiel Bestückungsautomaten, häufig Verwendung finden.

Die Aufgabe der Erfindung besteht weiter darin, eine Verwendung der Sensorplatte zur Qualifizierung von Substrate verarbeitenden Fertigungsprozessen anzugeben, bei dem vergleichsweise umfassende Daten über den Fertigungsprozess gewonnen werden können.

Erfindungsgemäß wird diese Aufgabe dadurch gelöst, dass die erfindungsgemäße Sensorplatte als Ersatz für das zu verarbeitende Substrat verwendet und so der zu qualifizierende Prozessschritt simuliert wird.

Gemäß einer Ausgestaltung der Verwendung ist der im Verfahren zu qualifizierende Prozessschritt ein Medientransfer auf das Substrat. Unter einem Medientransfer soll in diesem Zusammenhang das Aufbringen von Medien auf das Substrat verstanden werden. Ein typischer Medientransfer ist beispielsweise das Aufbringen von Lötwerkstoff oder von Schichten, welche die Funktion der mit Hilfe des Substrates zu fertigenden Baueinheit mitbestimmen oder für den Ablauf des das Substrat verarbeitenden Fertigungsprozesse von Bedeutung sind. Hierbei handelt es sich im ersten Fall beispielsweise um Schutzlackschichten oder Leitschichten, aus welchen die Leiterbahnen gebildet werden können. Im zweiten Falle können beispielsweise maskenartige Ätzstoppschichten gebildet werden, welche die beschichteten Bereiche des Substrates bei einer nachfolgenden Ätzbehandlung schützen. Der Medientransfer kann durch alle zu diesem Zweck bekannten Verfahren erfolgen. Als Beispiele seien das Dispensen, Sprühen, Schäumen, Vakuumbeschichten und Drucken (Schablonendruck, Tampondruck) aufgeführt.

Eine Anwendung für Substrate verarbeitende Fertigungsprozesse mit Medientransfer liegt in der Mikrofluidik, wobei das Substrat genutzt wird, um in dieses Kanalstrukturen zur Bildung eines Fluidsystems beispielsweise durch Ätzen einzubringen.

Gemäß einer weiteren Ausgestaltung der Verwendung ist der zu qualifizierende Prozessschritt eine Aufbringung einer Maske auf das Substrat. Durch Anwendung dieses Verfahrens kann vorteilhaft die Qualität einer Maske überprüft werden. Derartige Masken werden vorrangig zur Durchführung der schon erwähnten Schablonendrucke oder auch zum Ätzen verwendet und unterliegen einem gewissen Verschleiß. Durch die Qualifizierung der Masken kann daher in in vorteilhafter Weise festgestellt werden, wann diese aufgrund des Materialverschleißes ausgewechselt werden müssen. Außerdem kann eine Qualitätsüberprüfung neu gefertigter Masken erfolgen.

Eine zusätzliche Ausgestaltung der Verwendung sieht vor, dass der zu qualifizierende Prozessschritt aus einer Positionierung des Substrates in einer für den Fertigungsprozess vorgesehenen Fertigungseinrichtung besteht. Hierdurch kann der Fertigungsprozess in einer Fertigungseinrichtung daraufhin überprüft werden, ob das Substrat richtig in der Fertigungseinrichtung positioniert wurde. Dabei wird das Substrat durch die Sensorplatte ersetzt. Hierdurch ist ein Rückschluss auf die richtige Positionierung des Substrates möglich. Damit kann vorteilhafterweise ein für den Fertigungsprozess am Substrat wichtiger Prozessschritt qualifiziert werden, da eine Lageabweichung bei der Positionierung des Substrates in der Fertigungseinrichtung in der Folge zu Ungenauigkeiten bei der Positionierung von Bauelementen auf dem Substrat führen würde.

Gemäß einer Ausgestaltung dieser Erfindung erfolgt die Qualifizierung der Positionierung durch die Ermittlung der Auflagefläche der Sensorplatte in der Fertigungseinrichtung. Dieser Qualifizierungsvorgang ist besonders einfach durchführbar. Es ist lediglich der Ersatz des Substrates durch die Sensorplatte notwendig, mit deren Hilfe Positionierungenauigkeiten direkt ermittelt werden können.

Eine andere Ausgestaltung dieser Erfindung sieht vor, dass die Positionierung durch die Erfassung eines Signals, welches durch einen in definierter Lage der Fertigungseinrichtung befindlichen Signalgeber erzeugt wird, mittels der Sensorplatte erfolgt. Ein solcher Signalgeber kann beispielsweise aus einer elektrischen Spule bestehen, mit deren Hilfe ein elektromagnetisches Feld erzeugt werden kann. Ist diese Spule in definierter Lage in der Fertigungseinrichtung positioniert, so kann durch die Erfassung des von der Spule ausgehenden Magnetfeldes die Lage der Sensorplatte ermittelt werden, wobei dabei die Voraussetzung erfüllt sein muss, dass das Messergebnis der Sensorplatte durch das Magnetfeld beeinflusst wird. Ein weiterer Vorteil ist darin zu sehen, dass die Funktion der Sensorplatte mittels des durch den Signalgeber ausgesandten Signals überprüft werden kann, weil die Eigenschaften dieses Signals bekannt sind und so das Messergebnis der Sensorplatte mit einem Sollergebnis verglichen werden kann.

Gemäß einer besonderen Ausgestaltung aller oben aufgeführten Verwendungen wird zur Qualifizierung des Fertigungsprozesses das Messergebnis der Sensorplatte mit einem Musterergebnis verglichen. Hierbei wird vorteilhafterweise ein Fehler im Fertigungsprozess unproblematisch aufgedeckt, wenn sich zwischen Messergebnisses und Musterergebnis eine Abweichung ergibt, welche außerhalb eines für das Messergebnis zugestandenen Toleranzbereiches liegt. Die Muster lassen sich dabei auf einfachste Weise dadurch erzeugen, dass ein fehlerfreier Musterprozess mit der Sensorplatte durchgeführt wird und die gemessenen Daten als Muster abgespeichert werden. Hierdurch ist eine hohe Effizienz möglich, da eine komplizierte Dateneingabe für das Musterergebnis entfallen kann.

Weitere Einzelheiten der Erfindung werden anhand der Zeichnung erläutert. Hierbei zeigt
Figur 1 die schematische Darstellung eines Ausführungsbeispieles einer Fertigungseinrichtung,
Figur 2 den schematischen Schnitt durch ein Ausführungsbeispiel einer thermisch sensitiven Sensorplatte,
Figur 3 die schematische Aufsicht auf ein Ausführungsbeispiel einer kapazitiv sensitiven Sensorplatte,
Figur 4 den Schnitt A-A gemäß Figur 3,
Figur 5 ein typisches elektronisches Bauelement als Aufsicht,
Figur 6 schematisch ein Muster, welches ein Bauelement gemäß

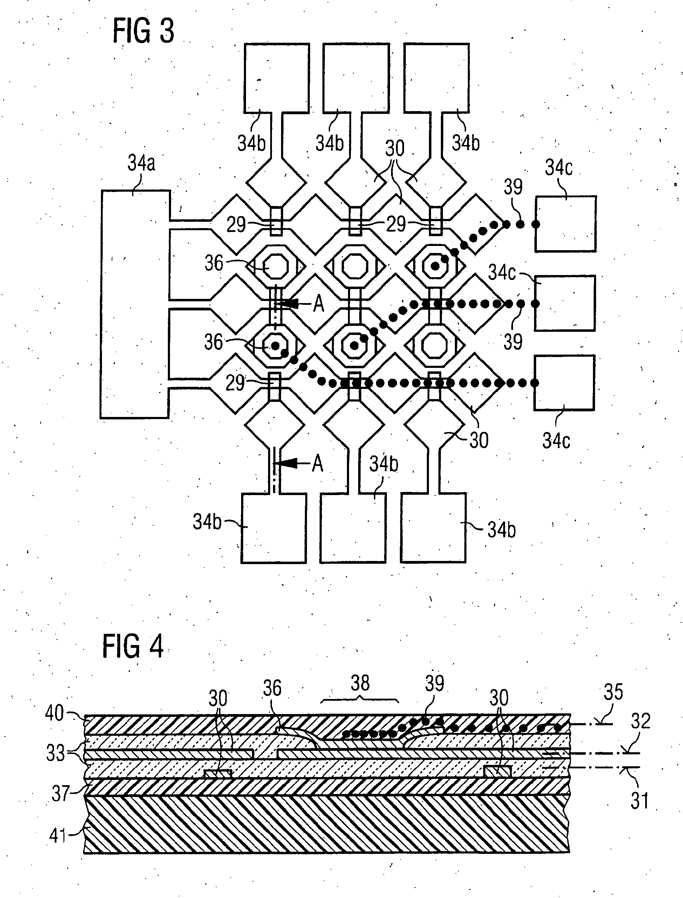

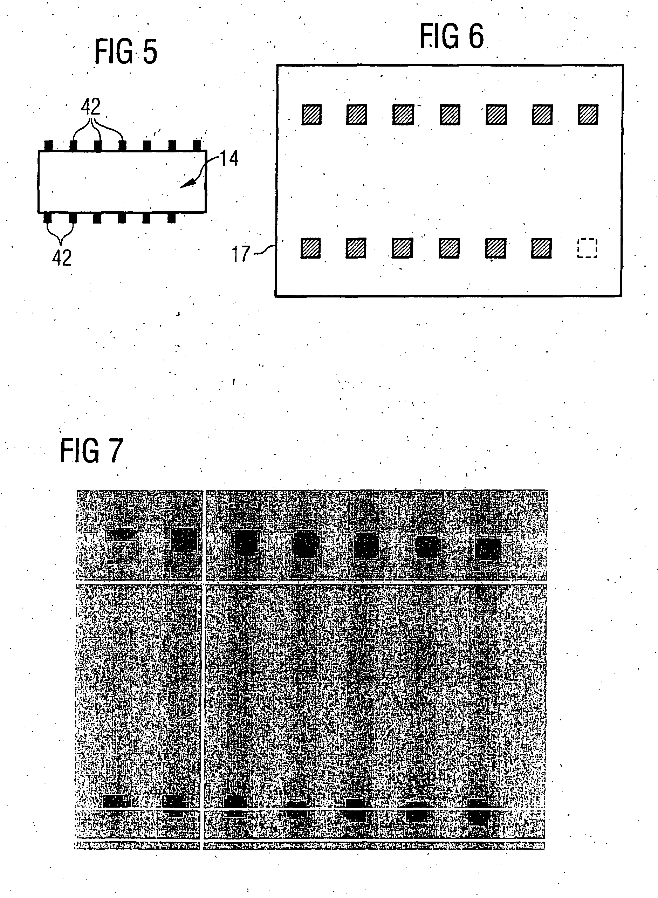

Figur 5 auf einer Sensorplatte gemäß Figur 3 erzeugt und
Figur 7 ein Messergebnis gemäß Figur 6, wie es bei Versuchen mit einem elektronischen Bauelement gemäß Figur 5 erzielt wurde.

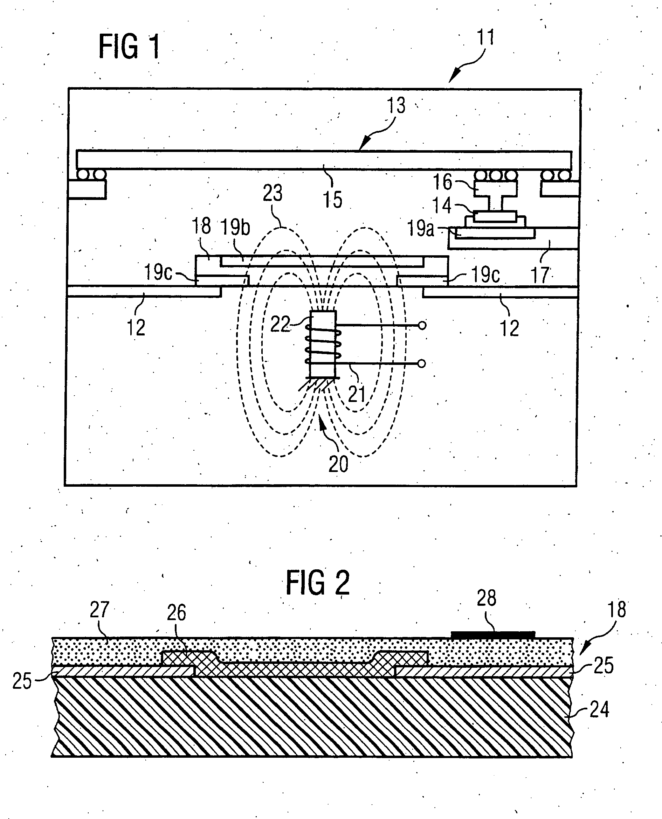

In Figur 1 ist schematisch eine Fertigungseinrichtung 11 dargestellt, die als Bestückungsautomat ausgebildet ist. Zur Durchführung einer Bestückung weist die Fertigungseinrichtung 11 eine Auflage 12 für ein nichtdargestelltes Substrat auf. Mit Hilfe einer Bestückungsvorrichtung 13 kann ein Bauelement 14 gehandhabt werden. Hierzu ist die Bestückungsvorrichtung 13 mit einer senkrecht zur Zeichenebene verschiebbaren Traverse 15 und einem auf der Traverse beweglichen Greifer 16 für das Bauelement 14 versehen.

Der Greifer 16 kann das Bauelement 14 vor dem Bestückungsvorgang auf eine erste Sensorplatte 17 absetzen, wobei eine Erkennung des Bauelementes durch einen Vergleich des Messergebnisses der Sensorplatte mit einem in einer nicht dargestellten Auswertungseinrichtung abgespeicherten Muster erfolgt.

Anstelle eines Substrates ist auf der Auflage 12 der Fertigungseinrichtung 11 mit eine zweiten Sensorplatte 18 positioniert, die den Abmessungen des zu bestückenden Substrates entspricht. Auf diese kann das zuvor durch die erste Sensorplatte untersuchte Bauelement abgesetzt werden.

Auf den Sensorplatten 17, 18 sind sensitive Bereiche 19a, b, c gebildet. Die erste Sensorplatte weist den sensitiven Bereich 19a auf, welcher in seinen Abmessungen genügend groß ist, dass das Bauelement 14 erfasst werden kann. Die zweite Sensorplatte 18 weist in dem zur Bestückung vorgesehenen Bereich auf einer Seite den sensitiven Bereich 19b auf. Auf der der Bestückung abgewandten Seite der zweiten Sensorplatte befindet sich der sensitive Bereich 19c, der am Rand dieser Seite ringförmig umläuft, wodurch die Auflagefläche auf der Auflage 12 ermittelt werden kann.

Weiterhin ist in der Fertigungseinrichtung 11 ein Signalgeber 20 ortsfest vorgesehen, welcher aus einer elektrischen Spule 21 und einem ferromagnetischem Kern 22 besteht. Durch den Signalgeber 20 lässt sich ein angedeutetes Magnetfeld 23 erzeugen, welches die zweite Sensorplatte 18 durchdringt und auf diese Weise in der zweiten Sensorplatte 18 ein definiertes Messergebnis erzeugt. Dieses kann mit einem Musterergebnis verglichen werden, wodurch die korrekte Lage der zweiten Sensorplatte 18 in der Fertigungseinrichtung 11 ermittelt wird.

In Figur 2 ist ein Ausschnitt aus einer Sensorplatte im Schnitt dargestellt. Die Sensorplatte 18 ist durch Beschichtung einer Trägerplatte 24 gebildet. Beispielsweise mittels Vakuumbeschichtung können auf die Trägerplatte Leiterbahnen 25 aufgebracht werden, welche durch einen ebenfalls mittels Vakuumbeschichtung hergestellten Wiederstand 26 verbunden werden. Anschließend wird eine Schutzschicht 27 aufgebracht, die aus einem elektrischen Isolator besteht. Zusätzlich kann eine Markierung 28, beispielsweise in Form eines Punktes, als Lackschicht aufgebracht werden, welche als optischer Orientierungspunkt für eine lagegenaue Ausrichtung der Sensorplatte 18 in einer nicht dargestellten Fertigungseinrichtung dient.

Der Wiederstand 26 dient gleichzeitig als Heiz- und Messwiederstand. Durch Anlegen einer Spannung an die Leiterbahnen 25 wird der Wiederstand 26 aufgeheizt. Wird ein Gegenstand in die Nähe des Wiederstandes 26 gebracht, so nimmt dieser aufgrund seiner Wärmekapazität thermische Energie auf, was zu einer Abkühlung des Wiederstandes führt. Hierdurch wird auch sein spezifischer Wiederstand geändert, so dass die Abkühlung durch eine Wiederstandsmessung gemessen werden kann.

In Figur 3 ist schematisch eine Sensorplatte dargestellt, deren Sensorelemente 29 kapazitiv sensitiv sind. Dies bedeutet, dass die Sensorelemente miniaturisierte Kondensatoren bilden, mit denen ein Pixelraster der Matrix von Sensorelementen von 70 µm gebildet werden kann. Die Sensorelemente 29 sind durch sich kreuzende Leiterbahnen gebildet, wobei diese jeweils in einer ersten Messebene 31 und in einer zweiten Messebene 32 angeordnet sind (siehe Figur 4). Zwischen diesen Messebenen befindet sich ein elektrisch isolierender Füllstoff 33.

Wie Figur 3 zu entnehmen ist, sind die Leiterbahnen der ersten Messebene komplett an eine einzige Anschlussfläche 34a herangeführt. Ein Teil der Leiterbahnen der zweiten Messebene 32 ist jeweils einzeln an Anschlussflächen 34b herangeführt, welche in der zweiten Messebene liegen. Weitere Leiterbahnen der zweiten Messebene sind in eine Kontaktierungsebene 35 (siehe Figur 4) geführt, um eine durch fettgepunktete Linien angedeutete Kontaktierung mit Anschlussflächen 34c zu ermöglichen. Zu diesem Zweck sind die entsprechenden Leiterbahnen mittels einer Fenster-Durchkontaktierung 36 von der zweiten Messebene 32 in die Kontaktierungsebene 35 durchkontaktiert.

Der Figur 4 lässt sich weiterhin der Schichtaufbau der Sensorplatte entnehmen. Auf einer Trägerfolie 37 werden die Leiterbahnen 30 der ersten Messebene 31 aufgebracht und anschließend die Trägerfolie mit dem Füllstoff 33 beschichtet. Anschließend werden die Leiterbahnen 30 der zweiten Messebene 32 aufgebracht, wonach wiederum der Füllstoff 33 aufgebracht wird, wobei Fenster 38 freigelassen werden. Diese werden anschließend mit den Fensterdurchkontaktierungen 36 versehen, die mit Anschlussleitungen 39 in der Kontaktierungsebene 35 verbunden werden. Zuletzt wird eine Schutzschicht 40 aufgebracht. Der so gebildete Schichtverband wird zur Stabilisierung auf eine Trägerplatte 41 aufgebracht.

In Figur 5 ist das Bauelement 14 gemäß Figur 1 mit seitlich herausgeführten Kontaktbügeln 42 dargestellt, wobei aufgrund eines Fertigungsfehlers an der einen Ecke des Bauelementes ein Kontaktbügel fehlt.

In Figur 6 ist das Messergebnis der ersten Sensorplatte 17 gemäß Figur 1 schematisch dargestellt, welches das Bauelement 14 erzeugt. Es wird deutlich, dass die Annäherung der Kontaktbügel an die Oberfläche der ersten Sensorplatte 17 zu einer Kapazitätserhöhung der zugeordneten Sensorelemente (29 in Figur 3) führt, die in Figur 6 als Schwärzung hervortreten.

Das in Figur 6 erzeugte Messsignal kann mit einem Mustersignal verglichen werden, bei dem der in Figur 6 gestrichelte Bereich ebenfalls mit einer Schwärzung versehen ist. Durch einen Vergleich von Messsignal und Mustersignal kann der Fehler des Bauelementes 14 erkannt werden.

Mit Sensorplatten gemäß Figur 3 sind Versuche durchgeführt worden. Bei einer Annäherung von Bauelementen entsprechend dem in Figur 5 dargestellten konnte dabei ein Muster gemäß Figur 7 erzeugt werden.

## Patentansprüche

1. Sensorplatte (17, 18) zur Qualifizierung von Substrate verarbeitenden Fertigungsprozessen,
**dadurch gekennzeichnet,**
**dass** die Sensorplatte an mindestens einer Seite eine Matrix aus berührungsunabhängig kapazitiv sensitiven Sensorelementen (29) aufweist.

2. Sensorplatte nach Anspruch 1,
**dadurch gekennzeichnet,**
**dass** diese auf beiden Seiten jeweils eine Matrix aus Sensorelementen (29) aufweist.

3. Sensorplatte nach einem der vorangehenden Ansprüche,
**dadurch gekennzeichnet,**
**dass** diese eine Markierung (28) zur Bestimmung ihrer Lage in einer für den Fertigungsprozess vorgesehenen Fertigungseinrichtung (11) aufweist.

4. Verwendung einer Sensorplatte (17, 18) gemäß einem der Ansprüche 1 bis 3 als Ersatz für ein zu verarbeitendes Substrat, mit der ein zu qualifizierender Prozessschritt von Substrate verarbeitenden Fertigungsprozessen simuliert wird.

5. Verwendung nach Anspruch 4,
**dadurch gekennzeichnet,**
**dass** der zu qualifizierende Prozessschritt aus einem Medientransfer auf das Substrat durch Dispensen, Sprühen, Schäumen, Vakuumbeschichten oder Drucken besteht.

6. Verwendung nach Anspruch 5,
**dadurch gekennzeichnet,**
**dass** der Medientransfer aus einem Aufbringen von Lotwerkstoff besteht.

7. Verwendung nach Anspruch 5,
**dadurch gekennzeichnet,**
**dass** der Medientransfer aus einem Aufbringen von Schichten, insbesondere Schutzlackschichten oder Leitschichten zur Bildung von Leiterbahnen oder maskenartigen Ätzstoppschichten besteht.

8. Verwendung nach Anspruch 4,
**dadurch gekennzeichnet,**
**dass** der zu qualifizierende Prozessschritt aus einer Aufbringung einer Maske auf das Substrat besteht.

9. Verwendung nach Anspruch 8,
**dadurch gekennzeichnet,**
**dass** die Maske als Schablone auf das Substrat aufgesetzt wird.

10. Verwendung nach Anspruch 9,
**dadurch gekennzeichnet,**
**dass** mit der Schablone ein Drucken eines Mediums erfolgt.

11. Verwendung nach Anspruch 4,
**dadurch gekennzeichnet,**
**dass** der zu qualifizierende Prozessschritt aus einer Positionierung des Substrates in einer für den Fertigungsprozess vorgesehenen Fertigungseinrichtung (11) besteht.

12. Verwendung nach Anspruch 11,
**dadurch gekennzeichnet,**
**dass** die Positionierung durch die Ermittlung der Auflagefläche der Sensorplatte (17, 18) in der Fertigungseinrichtung (11) qualifiziert wird.

13. Verwendung nach Anspruch 11,
**dadurch gekennzeichnet,**
**dass** die Positionierung durch die Erfassung eines Signals, welches durch einen in definierter Lage in der Fertigungseinrichtung (11) befindlichen Signalgeber (20) erzeugt wird, mittels der Sensorplatte erfolgt.

14. Verwendung nach einem der vorherigen Ansprüche,
**dadurch gekennzeichnet,**
**dass** zur Qualifizierung des Fertigungsprozesses das Messergebnis der Sensorplatte mit einem Musterergebnis verglichen wird.

## Claims

1. Sensor plate (17, 18) for qualifying substrate-processing production processes,
**characterized in that**
the sensor plate has, on at least one side, a matrix of sensor elements (29) which are capacitively sensitive independently of contact.

2. Sensor plate according to Claim 1,
**characterized in that**
the sensor plate has a respective matrix of sensor elements (29) on both sides.

3. Sensor plate according to one of the preceding claims,
**characterized in that**
the sensor plate has a mark (28) for determining its position in a production device (11) provided for the production process.

4. Use of a sensor plate (17, 18) according to one of Claims 1 to 3 as a replacement for a substrate to be processed, which is used to simulate a process step of substrate-processing production processes which is to be qualified.

5. Use according to Claim 4,
**characterized in that**
the process step to be qualified consists of transferring media to the substrate by dispensing, spraying, foaming, vacuum-coating or printing.

6. Use according to Claim 5,
**characterized in that**
the media transfer consists of applying solder material.

7. Use according to Claim 5,
**characterized in that**
the media transfer consists of applying layers, in particular protective lacquer layers or conductive layers, in order to form conductor tracks or mask-like etching stop layers.

8. Use according to Claim 4,
**characterized in that**
the process step to be qualified consists of applying a mask to the substrate.

9. Use according to Claim 8,
**characterized in that**
the mask is placed onto the substrate as a template.

10. Use according to Claim 9,
**characterized in that**
the template is used to print a medium.

11. Use according to Claim 4,
**characterized in that**
the process step to be qualified consists of positioning the substrate in a production device (11) provided for the production process.

12. Use according to Claim 11,
**characterized in that**
the positioning operation is qualified by determining the bearing face of the sensor plate (17, 18) in the production device (11).

13. Use according to Claim 11,
**characterized in that**
the positioning operation is carried out by using the sensor plate to detect a signal which is generated by a signal generator (20) which is in a defined position in the production device (11).

14. Use according to one of the preceding claims,
**characterized in that**
the measurement result from the sensor plate is compared with a model result in order to qualify the production process.

## Revendications

1. Plaque (17, 18 ) de capteur pour la qualification de processus de fabrication traitant des substrats,
**caractérisée**
**en ce que** la plaque de capteur a, sur au moins une face, une matrice d'éléments ( 29 ) capteurs sensibles capacitivement en étant indépendants du toucher.

2. Plaque de capteur suivant la revendication 1,
**caractérisée**
**en ce qu'**elle a sur les deux faces une matrice d'éléments ( 29 ) capteurs.

3. Plaque de capteur suivant l'une des revendications précédentes,
**caractérisée**
**en ce qu'**elle a un repérage ( 28 ), pour la détermination de sa position dans un dispositif (11) de fabrication prévu pour le processus de fabrication.

4. Utilisation d'une plaque (17, 18) de capteur suivant l'une des revendications 1 à 3, en remplacement d'un substrat traité, par laquelle le stade du processus à qualifier parmi des processus de fabrication traitant des substrats est simulé.

5. Utilisation suivant la revendication 4,
**caractérisée**
**en ce que** le stade de processus à qualifier est constitué d'un transfert de milieu sur le substrat par distribution, pulvérisation, moussage, revêtement sous vide ou impression.

6. Utilisation suivant la revendication 5,
**caractérisée**
**en ce que** le transfert de milieu est constitué d'un dépôt de matériau de brasure.

7. Utilisation suivant la revendication 5,
**caractérisée**
**en ce que** le transfert de milieu est constitué d'un dépôt de couches, notamment de couches de vernis de protection ou de couches conductrices, pour la formation de couches conductrices ou de couches d'arrêt d'attaque de type en masque.

8. Utilisation suivant la revendication 4,
**caractérisée**
**en ce que** le stade de processus à qualifier est constitué d'un dépôt d'un masque sur le substrat.

9. Utilisation suivant la revendication 8,
**caractérisée**
**en ce que** le masque est posé en gabarit sur le substrat.

10. Utilisation suivant la revendication 9,
**caractérisée**
**en ce qu'**une impression d'un milieu s'effectue à l'aide du gabarit.

11. Utilisation suivant la revendication 4,
**caractérisée**
**en ce que** le stade de processus à qualifier est constitué d'un positionnement du substrat dans un dispositif (11) de fabrication prévu pour le processus de fabrication.

12. Utilisation suivant la revendication 11,
**caractérisée**
**en ce que** le positionnement est qualifié par la détermination de la surface d'application de la plaque ( 17, 18 ) de capteur dans le dispositif ( 11 ) de fabrication.

13. Utilisation suivant la revendication 11,
**caractérisée**
**en ce que** le positionnement s'effectue au moyen de la plaque de capteur par la détection d'un signal, qui est produit par un générateur ( 20 ) de signal se trouvant en position définie dans le dispositif ( 11 ) de fabrication.

14. Utilisation suivant l'une des revendications précédentes,
**caractérisée**
**en ce que**, pour la qualification du processus de fabrication, le résultat de mesure de la plaque de capteur est comparé à un résultat modèle.
